# EUROPEAN PATENT APPLICATION

(11) **EP 4 760 050 A1**
(43) Date of publication of application: **17.06.2026**
(21) Application number: 24307082.8
(22) Date of filing: 12.12.2024
(51) Int. Cl.: E21B 43/30

(54) **OPTIMIZING A LAYOUT OF A SUBSEA OIL & GAS FIELD**

(71) Applicant: TotalEnergies OneTech, 92400 Courbevoie (FR)
(72) Inventor: ALLYBOKUS, Zaïd, 64000 Pau (FR); LLOBELL, Baptiste, 64000 Pau (FR); PERCHOUX, Antoine, 64000 Pau (FR); PERONA, Noémie, 64000 Pau (FR); SCHMITT, Florent, 64000 Pau (FR)
(74) Representative: Bandpay & Greuter

(57) **Abstract**

The disclosure relates to a computer-implemented method for optimizing a layout of a subsea oil & gas field on a portion of the seabed, comprising providing input specifying locations unsuitable for well location and injection or production targets, determining optimal locations each of an injection well or of a production well by optimizing a well location and trajectory, determining optimal locations by performing an optimization that rewards every well is connected to exactly one drill center and the overall drilled length and number of drill centers is minimized, determining a location and orientation for the surface facility or processing facility based on metocean data, marine regulation constraints and the determined locations each of a drill center. The method also comprises determining a layout of flowlines by performing an optimization process including iterations of computing a solution to the optimization and defining mechanical constraints on the flowlines to find another solution.

## Description

### TECHNICAL FIELD

The disclosure relates to the field of computer programs and systems, and more specifically to a method, system and program for optimizing a layout of a subsea oil & gas field on a portion of the seabed.

### BACKGROUND

The design of subsea oil and gas fields has been gaining more and more importance. The location of production structures (e.g., wellheads, manifolds, ILT) on seabed has an impact in the overall deployment costs. Currently, the design of fields is performed via drawing tools. However, such tools require manual intervention, which is lengthy and cumbersome for design. Moreover, such tools do not take into account the network of flowlines present in the fields and do not take into account the constraints and trade-offs and geotechnical constraints.

Within this context, there is still a need for an improved method for optimizing a layout of a subsea oil & gas field on a portion of the seabed.

### SUMMARY

It is therefore provided a computer-implemented method for optimizing a layout of a subsea oil & gas field on a portion of the seabed. The method comprises providing inputs. The inputs include data specifying one or more seabed locations unsuitable for well location based on terrain exclusion zones. The inputs also include data specifying one or more injection or production targets to hydrocarbon reservoirs. The method also comprises determining one or more optimal locations each of an injection well or of a production well by optimizing, based on the inputs, a well location and a well trajectory. The method also comprises determining one or more optimal locations each of a drill center. This determination is made by performing an optimization. The optimization is based on the inputs and on the determined optimal locations each of an injection well or of a production well. The optimization rewards the following criteria: every well is connected to exactly one drill center; and the overall drilled length and number of drill centers is minimized. The method also comprises determining a location and orientation for the subsea oil & gas (*i.e.* oil and gas) surface or processing facility based on metocean data and/or marine regulation constraints and the determined locations each of a drill center. The method also comprises determining a layout of flowlines of the subsea oil & gas field for connection between the surface or processing facility and the drill centers. This determination is made by performing an optimization process. that the optimization process aims at minimizing a total length of the flowlines while respecting mechanical constraints and/or installation constraints on the flowlines. The optimization process includes one or more iterations of: computing a solution to the optimization; and by the user, defining one or more mechanical constraints and/or installation constraints on the flowlines to find another solution.

The method may comprise one or more of the following:
- computing the solution comprises applying a column generation algorithm that provides an optimal flowline deployment solution;
- the one or more mechanical constraints and/or installation constraints comprises one or more of:
   ∘ no flowline intersection;
   ∘ maximal and/or minimal flowline curvature;
   ∘ forbidding of a connection;
   ∘ locking and/or forcing a connection; and/or
   ∘ modifying the local geometry of a flowline by adding waypoints, changing curvature, straight line portions at drill center neighborhood;
- computing a solution to the optimization comprises:
   ∘ optimizing a flowline-drill center assignment; and
   ∘ optimizing a geometry of the flowlines traversing each assigned drill center while minimizing length and avoiding exclusion zones;
- the data specifying one or more target hydrocarbon reservoirs and one or more seabed locations unsuitable for well location include data specifying one or more of the following:
   ∘ target reservoir coordinates;
   ∘ bathymetry;
   ∘ pockmarks;
   ∘ slopes;
   ∘ zones excluded because of shipwrecks and/or biodiversity; and/or
   ∘ existing facilities;
- the inputs further include data specifying one or more of the following:
   ∘ a type of the surface facility or processing facility;
   ∘ flowline types;
   ∘ riser types technologies and constraints;
   ∘ allowed curvatures, crossings, pipebrakes; and/or
   ∘ drilling constraints, including DogLegSeverity, allowed azimuth change, allowed deviation, allowed maximum trajectory slant, allowed terrain for wellhead and/or structure placement; and/or
- the method further comprises minimizing development metrics including a type of flowline and riser and/or an incentive for additional structu res.

It is further provided a computer program comprising instructions for performing the method.

It is further provided a computer readable storage medium having recorded thereon the computer program.

It is further provided a computer system comprising a processor coupled to a memory, the memory having recorded thereon the computer program.

### BRIEF DESCRIPTION OF THE DRAWINGS

Non-limiting examples will now be described in reference to the accompanying drawings, where:
- FIG. 1 shows a flowchart of an example of the method;
- FIG. 2 shows an example of the system; and
- FIG.s 3 to 9 show examples of the method.

### DETAILED DESCRIPTION

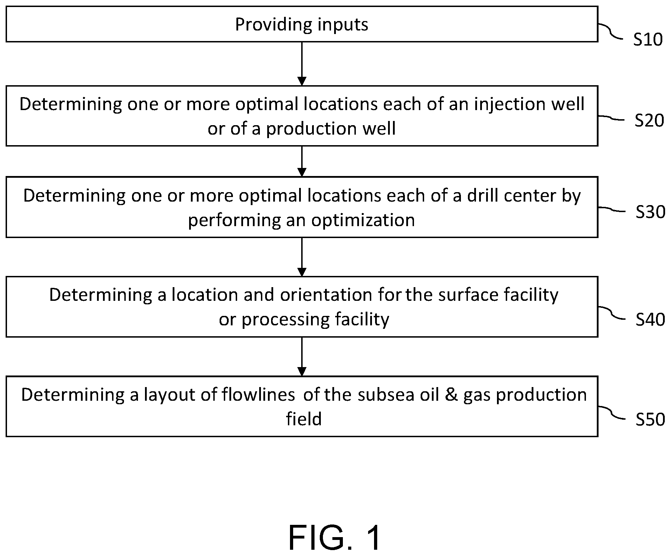

With reference to the flowchart of FIG. 1, it is proposed a computer-implemented method for optimizing a layout of a subsea oil & gas field on a portion of the seabed.

The method comprises providing S10 inputs. The inputs include data specifying one or more seabed locations unsuitable for well location based on terrain exclusion zones. The inputs also include data specifying one or more injection or production targets to hydrocarbon reservoirs.

The method also comprises determining one or more optimal locations S20 each of an injection well or of a production well. The determining is by optimizing, based on the inputs, a well location and a well trajectory.

The method also comprises determining one or more optimal locations S30 each of a drill center by performing an optimization. The optimization is based on the inputs and on the determined optimal locations each of an injection well or of a production well. The optimization rewards the following criteria: every well is connected to exactly one drill center and the overall drilled length and number of drill centers is minimized.

The method also comprises determining a location and orientation S40 for the surface or processing facility . The determining is based on metocean data and the determined locations each of a drill center.

The method also comprises determining a layout S50 of flowlines of the subsea oil & gas field for connection between the surface or processing facility and the drill centers. Determining the layout is by performing an optimization process. The optimization process aims at minimizing a total length of the flowlines while respecting mechanical constraints and/or installation constraints on the flowlines.

The optimization process performed at S50 includes one or more iterations of: computing a solution to the optimization and, by the user, defining one or more mechanical constraints and/or installation constraints on the flowlines to find another solution.

The method thus improves optimization of the layout of the subsea oil & gas field on the portion of the seabed. Indeed, the method takes into account the input data S10 that specifies the one or more seabed locations unsuitable for well location based on terrain exclusion zones and one or more injection or production targets to hydrocarbon reservoirs. Thus, the locations of the injection well or the production well, and the drill center S20 are determined to be located so as to obtain the maximum efficiency possible (so that the injection well or the production well reach the target) for connecting injection targets (e.g., production or injection targets) to hydrocarbon reservoirs all while taking into account the constraints set by such seabed locations, e.g., the biodiversity, faults, pockmarks present in the seabed locations.

Moreover, as the one or more optimal location of each drill center S30 is based on rewarding optimization criteria, the method outputs a designed layout that encourages an efficient connection between the overall drilled length and number of drill centers is minimized, all while enforcing that every well is connected to exactly one drill center. Thus, the layout respects the structural constraints of each drill center with respect to the inputs and the optimal locations each of an injection well or of the production well.

In addition, as the method determines S40 the location and orientation for the surface or processing facility based on metocean data and the determined locations each of a drill center, the method ensures that the layout follows geotechnical constraints set by the metocean data, and thus improves the safety of operation of the surface or processing facility.

Furthermore, as the layout of flowlines connecting the surface or processing facility and the drill centers are determined by the optimization process S50, the method obtains a design in which the flowlines have a minimal length while respecting the mechanical constraints and/or installation constraints, thereby obtaining a high efficiency for the flowlines, and thus enabling the injection well or the production well to achieve their respective production targets. Moreover, the optimization process S50 is iterative, and thus the user can define one or more mechanical constraints and/or installation constraints needed at any iteration, e.g., upon receiving a new production target or when having a change on one seabed location, e.g., a new fault appearing. Thus, the method can update the layout design so as to respond to the user's needs.

The method thus enables informed decision-making for deploying/installing a surface or processing facility on the subsea oil & gas field, thereby enhancing operational efficiency in hydrocarbon reservoir management on the subsea oil & gas field.

The method may be part of a process for deploying/installing surface or processing facility on the physical subsea oil & gas field. The process may comprise placing the injection well or the production well on the determined one or more optimal locations. The process may also comprise placing each drill center on a corresponding determined optimal location. The process may comprise placing the layout of flowlines taking into account the result of the optimization process. Indeed, the process generates a final configuration of the flowlines connecting the surface or processing facility and the drill centers based on the method. The deployed layout thus minimizes the total length of the flowlines while satisfying the mechanical, environmental, and operational constraints. Optionally, the process may further comprise extracting oil & gas from the subsea oil & gas field.

The deployed surface or processing facility has thus an improved production efficiency as the flowlines take into account the results of the optimization, which take into account the geological constraints present on the seabed all while maximizing productivity set by the one or more injection targets.

The method is computer-implemented. This means that steps (or substantially all the steps) of the method are executed by at least one computer, or any system alike. Thus, steps of the method are performed by the computer, possibly fully automatically, or, semi-automatically. In examples, the triggering of at least some of the steps of the method may be performed through user-computer interaction. The level of user-computer interaction required may depend on the level of automatism foreseen and put in balance with the need to implement user's wishes. In examples, this level may be user-defined and/or pre-defined.

A typical example of computer-implementation of a method is to perform the method with a system adapted for this purpose. The system may comprise a processor coupled to a memory and a graphical user interface (GUI), the memory having recorded thereon a computer program comprising instructions for performing the method. The memory may also store a database. The memory is any hardware adapted for such storage, possibly comprising several physical distinct parts (e.g. one for the program, and possibly one for the database).

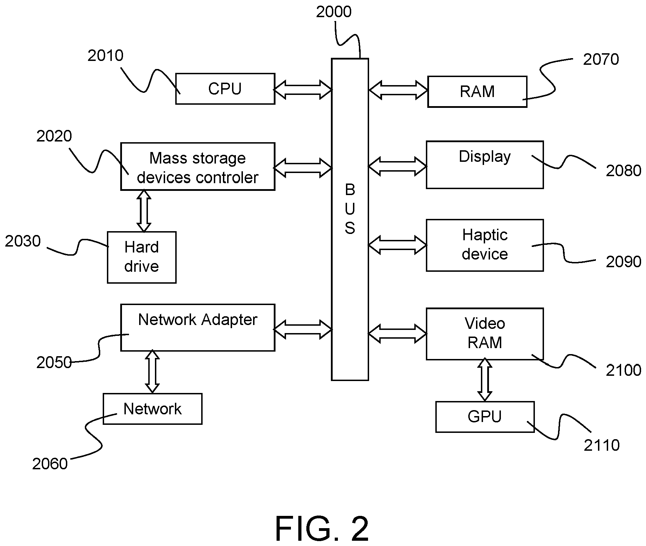

FIG. 2 shows an example of the system, wherein the system is a client computer system, e.g. a workstation of a user.

The client computer of the example comprises a central processing unit (CPU) 2010 connected to an internal communication BUS 2000, a random access memory (RAM) 2070 also connected to the BUS. The client computer is further provided with a graphical processing unit (GPU) 2110 which is associated with a video random access memory 2100 connected to the BUS. Video RAM 2100 is also known in the art as frame buffer. A mass storage device controller 2020 manages accesses to a mass memory device, such as hard drive 2030. Mass memory devices suitable for tangibly embodying computer program instructions and data include all forms of nonvolatile memory, including by way of example semiconductor memory devices, such as EPROM, EEPROM, and flash memory devices; magnetic disks such as internal hard disks and removable disks; magneto-optical disks. Any of the foregoing may be supplemented by, or incorporated in, specially designed ASICs (application-specific integrated circuits). A network adapter 2050 manages accesses to a network 2060. The client computer may also include a haptic device 2090 such as cursor control device, a keyboard or the like. A cursor control device is used in the client computer to permit the user to selectively position a cursor at any desired location on display 2080. In addition, the cursor control device allows the user to select various commands, and input control signals. The cursor control device includes a number of signal generation devices for input control signals to system. Typically, a cursor control device may be a mouse, the button of the mouse being used to generate the signals. Alternatively or additionally, the client computer system may comprise a sensitive pad, and/or a sensitive screen.

The computer program may comprise instructions executable by a computer, the instructions comprising means for causing the above system to perform the method. The program may be recordable on any data storage medium, including the memory of the system. The program may for example be implemented in digital electronic circuitry, or in computer hardware, firmware, software, or in combinations of them. The program may be implemented as an apparatus, for example a product tangibly embodied in a machine-readable storage device for execution by a programmable processor. Method steps may be performed by a programmable processor executing a program of instructions to perform functions of the method by operating on input data and generating output. The processor may thus be programmable and coupled to receive data and instructions from, and to transmit data and instructions to, a data storage system, at least one input device, and at least one output device. The application program may be implemented in a high-level procedural or object-oriented programming language, or in assembly or machine language if desired. In any case, the language may be a compiled or interpreted language. The program may be a full installation program or an update program. Application of the program on the system results in any case in instructions for performing the method. The computer program may alternatively be stored and executed on a server of a cloud computing environment, the server being in communication across a network with one or more clients. In such a case a processing unit executes the instructions comprised by the program, thereby causing the method to be performed on the cloud computing environment.

The method is for optimizing a layout of a subsea oil & gas field. In other words, the method is for leveraging from optimization to select the most efficient layout of flowlines (as output by the optimization) and other infrastructure (e.g., in the form of injection well, production well and/or drill centers) that conforms to the constraints set forth by the portion of the seabed and to mechanical constraints and/or installation constraints set by production needs. The infrastructure may also comprise, e.g., a surface or processing facility at a predetermined location, a floating platform and/or a riser section between the flowlines and the floating platform. The layout may be deployed on a production field that is, where there is already infrastructure for production, and/or on injection systems.

The method comprises providing S10 inputs. The inputs S10 may be provided from user input. The one or more locations unsuitable for well location may be obtained from the result of geological simulations or geological measurements, as known in the art. The one or more injection or production targets may be obtained from production/efficiency requirements for the hydrocarbon reservoirs. The one or more locations unsuitable for well location are based on terrain exclusion zones. A terrain exclusion zone may refer to any relevant terrain feature of the portion of the seabed that may adversely affect the integrity or environmental safety of the seabed, or may yield to operational hazards. The terrain exclusion zone may comprise, e.g., biodiversity hotspots, seismic faults, pockmarks. The terrain exclusion zone may also comprise zones having existing facilities located therein.

The inputs, provided at S10, also include data specifying one or more injection or production targets to hydrocarbon reservoirs. The one or more injection or production targets may be the result of geological and/or geophysical analyses.

The data specifying one or more target hydrocarbon reservoirs and one or more seabed locations unsuitable for well location may include data specifying target reservoir coordinates. In examples, the method may comprise obtaining the target reservoir coordinates from a csv file. The method may identify the targets as endpoints of well trajectories to optimize from well location on the seabed. Based on the input rules that define feasible zones for well head placement, the method may finds a pool of best well location and best 3D trajectory responding to constrained mentioned above, connecting the target to the seabed. This pool permits to build the optimization problem.

The data may also include data specifying bathymetry. In examples, the method may comprise obtaining the bathymetry as a tif image and convert it into an array that forms a look up table to get the depth at any point (x,y) corresponding to a pixel of the image. The method may use this lookup table to define an anchor (of a production facility, a surface facility or processing facility) and riser lengths, to define well head placement and well trajectory in 3D, and to output 3D developed flowline length.

The data may also include data specifying pockmarks. In examples, the method may comprise obtaining the data specifying pockmarks as input from a geodatabase or shapefile. This data is used to define exclusion zones for well placement, drill center placement, flowline routing and placement of the surface facility or processing facility.

The data may also include data specifying slopes. In examples, the method may obtain the data specifying slopes as input, e.g., in the form of a .tif image. The method may comprise transforming the image into an array that forms a look up table to get the slope at any point (x,y) corresponding to a pixel of the image. This lookup table is used to define drill center and well placement exclusion zones.

The data may also include data specifying zones excluded because of shipwrecks and/or biodiversity. The method may comprise obtaining the data from geodatabase or shapefile. This data is used to define exclusion zones for well placement, drill center placement, flowline routing and placement of the production facility, the surface facility or the processing facility.

The data may also include data specifying existing facilities, e.g., of production facilities, surface facilities and/or processing facilities already located on the seabed. The method may comprise obtaining the data from geodatabase or shapefile. This data is used to define exclusion zones for well placement, drill center placement, flowline routing and placement of the production facility, the surface facility or the processing facility.

The inputs provided at S10 may further include data specifying one or more of the following: a type of the surface facility or processing facility, flowline types, riser types technologies and constraints, allowed curvatures, crossings, pipebrakes; and/or drilling constraints. The drilling constraints may include DogLegSeverity, allowed azimuth change, allowed deviation, allowed maximum trajectory slant, allowed terrain for wellhead and/or structure placement.

The flowline type comprises data determining the geometry of the flowline. The flowline type may comprise a size, diameter, capacity, and architecture (e.g., dual production loop flowline, a hybrid loop flowline or a single line flowline).

The method comprises determining S20 one or more optimal locations each of an injection well or of a production well. The determination is by optimizing, based on the inputs, a well location and a well trajectory. In other words, the determination outputs the well location and the well trajectory as a result of an optimization of possible locations of the injection well or of the production well based on the constraints set by the provided inputs as a result of the optimizing performed at S20.

In examples, the method may perform the optimization at S20 by using an open source solver such as cbc.

The determination S20 may comprise taking as input the targets and the terrain data (bathymetry and slope, exclusion zones) provided at S10. The determination may create 3D trajectories for each target and for each point of a grid (modeling the portion of the seabed) covering the possible well placement zones and builds a pool of alternatives per target. Then for all these trajectories, the determination S20 may comprise selecting all the possible combinations of targets in drill centers: this means that these targets must be connected to wells close enough to each other to be in the same drill center, so deviation constraints come into play. The determination S20 may comprise building a pool of drill center alternatives. A drill center is therefore a location of the drill center, and one or more targets connected to this drill center through an optimized well trajectory. Then, the determination S20 may comprise creates an optimization model that expresses the objective of minimizing the drilled length (therefore the sum of the lengths of the wells of the drill centers that will be selected) and the number of drill centers deployed, with the constraint: any target is connected to a drill center.

The method comprises determining S30 one or more optimal locations each of a drill center by performing an optimization. The optimization performed at S30 is based on the inputs and on the determined (one or more) optimal locations each of an injection well or of a production well.

The optimization at S30 may be based on a loss function. The loss function may be of the type :
Sum (x[I]_{drilled length) ) + A * Sum(x[I]), where drilled length denotes a given drilled length and I denotes an index on the set of drill centers. The parameter A is an input data that allows the optimization of the drill length with respect to the deployment of the structures and flowlines. The parameter A may depend on each case.

As known from the field of optimization, the output of the optimization takes into account the inputs and the determined optimal locations as constraints for the optimal locations each of a drill center. Thus, the optimization at S30 penalizes locations of drill centers which enter into conflict with an injection well, e.g., the drill center being located too far from the injection well and/or the drill center being at a location unsuitable for well location, e.g., a location of a biodiversity hotspot, a fault or a pockmark.

The optimization performed at the determination S30 rewards the following criteria: the first criterion is that every well is connected to exactly one drill center and the second criterion is that the overall drilled length and number of drill centers is minimized. By "exactly" it is meant that there is no more than one drill center located in a respective well. The first criterion enhances that there is no more than one drill center located on a respective well while the second criterion enforces that the drill center is not located too far from an injection well.

In examples, the method may perform the optimization at S30 by using an open source solver such as cbc.

Metocean data refers to any combination of data relative to wind, wave and/or climate conditions on predetermined locations of the portion of the seabed. The metocean data may comprise, e.g., meteorology data (such as wind speed, direction, gustiness, wind rose and wind spectrum, air temperature, humidity), physical oceanography data (such as historical water level fluctuations, bathymetry, salinity, stratification). Marine regulation constraints may refer to any constraint based on a regulation or provision by marine authorities.

The determination S40 of the location and orientation for the surface facility or the processing facility is based on the metocean data. Alternatively or additionally, the determination may also be based on marine regulation constraints. The determination may also be based on the determined locations each of a drill center. A surface facility or processing facility disclosed herein may be any facility for processing and/or production on the subsea oil & gas field, for example including risers and or floating platforms. In other words, the determination S40 of the location and the orientation is based on meteorology and oceanography data available for the portion of the seabed and on the determined locations each of a respective drill center. Thus, the method takes into account the productivity of each drill center while being subject to the constraints of the metocean data and/or marine regulation constraints, all while taking into account constraints on the seabed, e.g., due to bathymetry, geo-hazards (as captured by the metocean data) and location of existing facilities. Indeed, the location of surface facilities and production facilities is also affected by bathymetry and potential geo hazards.

The method comprises determining S50 a layout of flowlines of the subsea oil & gas field. The layout is for connection between the surface facility or the processing facility and the drill centers.

The determination S50 is by performing an optimization process. The optimization process aims at minimizing a total length of the flowlines while respecting mechanical constraints and/or installation constraints on the flowlines.

In examples, the portion of the seabed may be modeled as a 3D grid. The 3D grid may be made of cells. Each cell may represent a respective geological feature of the portion of the seabed. A location on the portion of the seabed may be defined by a 3D location of at least one cell of the 3D grid.

By "flowline" it is meant a path representing a tube configured to transport oil and/or gas. In examples, a flowline of the present disclosure may be represented as a 3D trajectory intersecting cells of the 3D grid.

The optimization process S50 minimizes the total length of the flowlines while respecting the mechanical constraints and/or installation constraints of the flowlines. The mechanical constraints may comprise, e.g., tension, bending limits, fatigue constraints and/or resistance constraints. The installation constraints may comprise any kind of constraint on the installation of the flowline, e.g., locking or forcing a connection. The optimization thus rewards the shortest length possible of the flowlines (as these traverse the portion of the seabed) all while respecting mechanical constraints and/or installation constraints, so that the output by the method has a physically relevant meaning. For example, the optimization at S50 may penalize sharp turns, abrupt stops, or narrow flowlines.

The optimization process performed at S50 includes one or more iterations of computing a solution to the optimization.

In examples, the optimization process performed at S50 may comprise initializing flowlines on the 3D grid covering the possible locations of the injection wells or production well and build a pool of alternatives per target. The optimization process S50 may comprise iterating the trajectory of the flowlines on the 3D grid so that the solution has a final optimal solution. For example, the optimization process may test a path representing flowline connecting the subsea oil & gas field connecting a drill center on the 3D grid, while respecting the mechanical constraints and/or installation constraints (e.g., including not overlapping another flowline) and while respecting locations unsuitable for well location all while maintaining a total length. If the conditions are satisfied, the optimization process may stop. Else, the method may test another path. The optimization process performed at S50 thereby covers all possible locations while minimizing the total length while respecting the total length.

The iteration also comprises including, by the user, defining one or more mechanical constraints and/or installation constraints on the flowlines to find another solution. In other words, involves iterations (e.g., one or more, e.g., two or more) of the optimization in which a preliminary solution for the flowline layout is computed based on the current set of constraints at a respective iteration. Following each computed solution, the user defines (or adjusts) one or more mechanical constraints and/or installation constraints on the flowlines at the next iteration so as to refine the solution. Thus, the optimization ensures compliance with the user input as the optimization advances.

The method thus improves the layout of the subsea oil & gas field on the portion of the seabed.

Indeed, the provided inputs together with the one or more seabed locations unsuitable for well altogether with the one or more injection or production targets enable the method to provide locations for the injection or production well so as to ensure optimal placement for efficient hydrocarbon extraction all while respecting environmental constraints set by terrain exclusion zones.

Thus, the one or more optimal locations of the injection well or the production well, determined at S20, take into account geospatial and environmental factors specified in the input data, including terrain exclusion zones (such as biodiversity-sensitive areas, seismic faults, and geological features like pockmarks and/or existing facilities) and predefined targets within hydrocarbon reservoirs. By taking into account these parameters, the method identifies well or production well locations that maximize extraction efficiency when establishing the layout of flowlines all while minimizing environmental risks.

In addition, thanks to the determination S30, the method thus identifies ideal locations for drill centers that enable efficient resource allocation and reduce infrastructure costs.

Moreover, thanks to the determination S40, the method also takes into account the metocean conditions data for the location and orientation of the surface facility or the processing facility. Thus, the method establishes an optimal configuration for the subsea field that aligns with site-specific metocean data, thereby enhancing the safety, and performance of the field infrastructure.

In addition, the iterative approach of the optimization S50 enables the method to progressively adjust the flowline layout, balancing the objective of minimizing flowline length with the requirement to meet mechanical and requirements of the user. The result is an optimized and compliant flowline network that connects the surface facility or the processing facility to the drill centers with minimized material and installation costs.

In examples, the method may comprise taking as input at S10 the targets (i.e., the injection or production targets to hydrocarbon reservoirs) and the one or more seabed locations unsuitable for well location based on terrain exclusion zone (e.g., terrain data such as bathymetry and slope, exclusion zones). The method may build 3D trajectories (representing the layout of flowlines) for each target and for each point of a grid covering the possible locations of the injection wells or production well and build a pool of alternatives per target (i.e., the output of the determination S50). For all these trajectories, the method may from the determination S20 and S30 all the possible combinations of targets in each drill center: this means that these targets must be connected to wells close enough to each other to be in the same drill center, so deviation constraints come into play. The method therefore builds a pool of drill center alternatives. A drill center is therefore a location of the drill center, and one or more targets connected to this drill center through an optimized well trajectory. Then, the method creates an optimization model at S50 that expresses the objective of minimizing the drilled length (therefore the sum of the lengths of the wells of the drill centers that will be selected) and the number of drill centers deployed, with the constraint: any target is connected to a drill center.

Computing the solution may comprise applying a column generation algorithm that provides an optimal flowline deployment solution. The column generation algorithm may iteratively refine and optimize the flowline deployment, e.g., by solving a series of restrictions set forth by the columns. The optimization may comprise, at a given iteration where the user has defined one or more mechanical constraints and/or installation constraints on the flowline, introducing new columns representing potential flowline configurations. The new columns may be evaluated and integrated into the optimization to improve the overall deployment.

The mechanical constraints and/or installation constraints may be implemented mathematically in optimization as model constraints to change the optimization problem and provide a new solution respecting these constraints.

The column generation algorithm thus provides an optimal solution for deploying flowlines and asks the user if the obtained solution is satisfactory. If not, the user can define a set of additional constraints (including, for example, no crossing, prohibition of a connection, ...) that restrict the search space of the column generation, in which case the column generation starts a new series of iterations to converge towards the new optimal solution. This process propagates until the user is satisfied.

The method may comprise continuing the application of the column generation algorithm to adjust and optimize the flowline layout until reaching an optimal solution. The method thereby ensures ensuring that resource allocation, cost, and operational constraints are satisfied. The application of the column generation algorithm is advantageous for large-scale deployment scenarios, as the column generation approach significantly reduces the problem size at each iteration, leading to an optimal flowline layout design in a computationally efficient manner.

The method may further comprise minimizing development metrics. The minimization may include the selection and evaluation of a type of flowline and riser. Additionally or alternatively, the minimization may include an incentive for the addition of further structures. In other words, the method may take int account various flowline and riser configurations so as to output the flowlines. Thus, the method enables the most efficient and cost-effective arrangement while respecting the installation complexity.

In examples, may input project-specific data such as a size of flowline equipment, feasibility or not, and incentives for the optimization to accept flowline crossings or pipebreaks with a tradeoff, e.g., a crossing/pipebreak is acceptable after a number x of kilometers of flowline is saved.

The one or more mechanical constraints and/or installation constraints may comprise a no flowline intersection constraint. This enables the method to explore different scenarios, restricting the optimization to test crossings so as to asses the practical deployment of the flowline.

The one or more mechanical constraints and/or installation constraints may also comprise a maximal and/or minimal flowline curvature.

The one or more mechanical constraints and/or installation constraints may also comprise a forbidding of a connection. This enables the method to explore different scenarios, however possibly yielding a suboptimal result.

The one or more mechanical constraints and/or installation constraints may also comprise a locking and/or forcing a connection. This enables the method to explore different scenarios, for example for forcing a connection that may be otherwise forbidden.

The one or more mechanical constraints and/or installation constraints may also comprise a constraint on modifying the local geometry of a flowline by adding waypoints, changing curvature, straight line portions at drill center neighborhood. This enables the method to explore different scenarios, for example for forcing a change of curvature on the flowline and test if the change yields an improved result.

Computing a solution to the optimization may comprise optimizing a flowline-drill center assignment. The goal of the optimization is to minimize the constraints that each drill center is connected to the surface facility or the processing facility through a flowline, along with the mechanical constraints and/or installation constraints as described above and altogether with new user-defined constraints, that may be defined for exploration reasons.

Computing a solution to the optimization may also comprise optimizing a geometry of the flowlines traversing each assigned drill center while minimizing length and avoiding exclusion zones.

The method may comprise using a column generation algorithm to compute the solution, as described above.

The method may further comprise minimizing development metrics. Minimizing development metrics may include a type of flowline and riser and/or an incentive for additional structures. The use of an optimization based on column generation with constraints is adjustable on demand and according to experience.

Moreover, the method enables define networks of varied flowlines on demand. The consideration of curvature constraints in a network deployment problem so that it yields a physically relevant result. This is also enhanced with the joint optimization of two or three production/injection networks with coupling constraints (no crossing, collision).

In addition, the method has the advantage that it includes drilling constraints to propose the best aggregate solution in drill centers and the corresponding drilling trajectories.

For example, the method enables an arbitration between the deployment of a pipe break structure against a detour of a certain number x of kilometers.

The method is thus a solution that runs in real time and hence enables on-the-fly interactions, thus increasing productivity.

The method enables integration of subsea Layout design business rules while enabling human interaction so as to refine the layout design. The method has real-time response, thereby allowing real interaction.

Moreover, the method has a joint optimization at four levels (the surface facility or the processing facility, production network, production structure, drilling). The method may be implemented with open source libraries allowing easy deployment for internal businesses.

Examples of the method are now discussed, with reference to FIG.s 3 to 9.

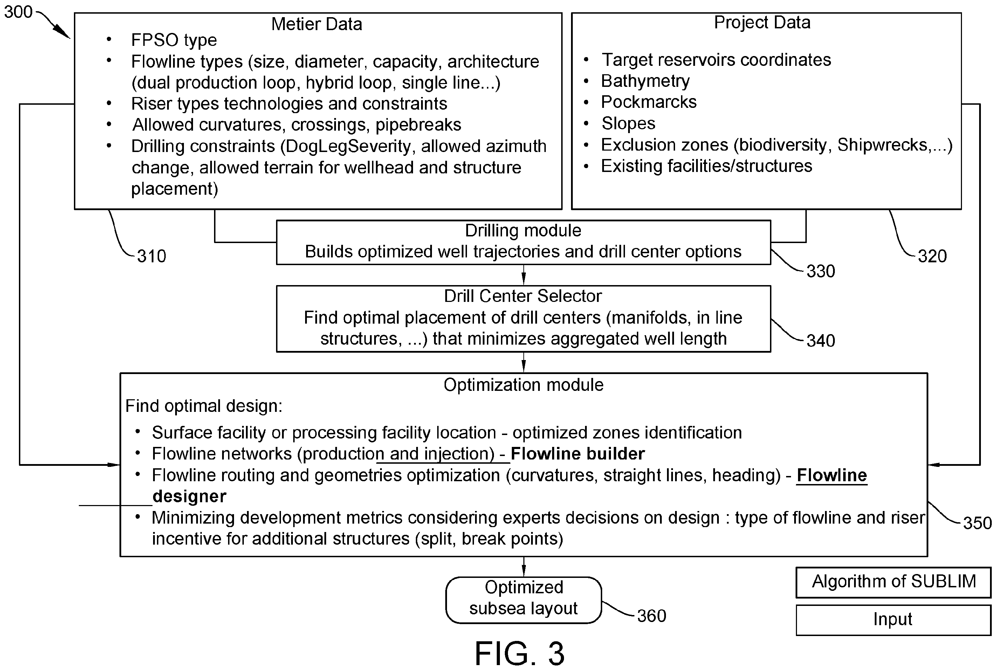

FIG. 3 shows a screenshot of a flowchart 300 of the method.

The flowchart 300 illustrates as input metier data 310 or deployment requirements of the surface facility or the processing facility. In other words, the input metier data comprises data of one or more injection or production targets to hydrocarbon reservoirs. The metier data comprises the type of the surface facility or the processing facility. The metier data also comprises flowline types, which includes, e.g., size, diameter, capacity, architecture (for example dual production loop, hybrid loop, single line), riser type technologies and constraints, allowed curvatures, crossings, pipebreaks, drilling constraints (e.g., dog leg severity, allowed azimuth change, allowed terrain for wellhead and structure placement).

The flowchart also includes as input project data 320 provided at S10. The project data includes one or more seabed locations unsuitable for well location, e.g., based on target reservoir coordinates, bathymetry, pockmarks, slopes, exclusion zones and existing facilities/structures.

The flowchart also illustrates a drilling module 330. The drilling module determines optimized well trajectories and drill center locations. In other words, the drilling module performs the determination S20.

The flowchart also illustrates a drill center selector 340. The drill center selection determines optimal locations for drill centers, e.g., on manifolds, in line structures) so as to minimize aggregated well length. In other words, the drill center selector performs the determination S30.

The flowchart also illustrates an optimization module 350. The optimization module is for determining the layout o flowlines S50. The module includes identifying optimized locations for production facilities, e.g., fields; flowline networks for production and injection, optimizing flowline routing and geometry (including curvatures, straight lines, headings) and minimizing development metrics including a type of flowline and riser and/or an incentive for additional structures, e.g., split or break points.

The method output as a result an optimized subsea layout 360.

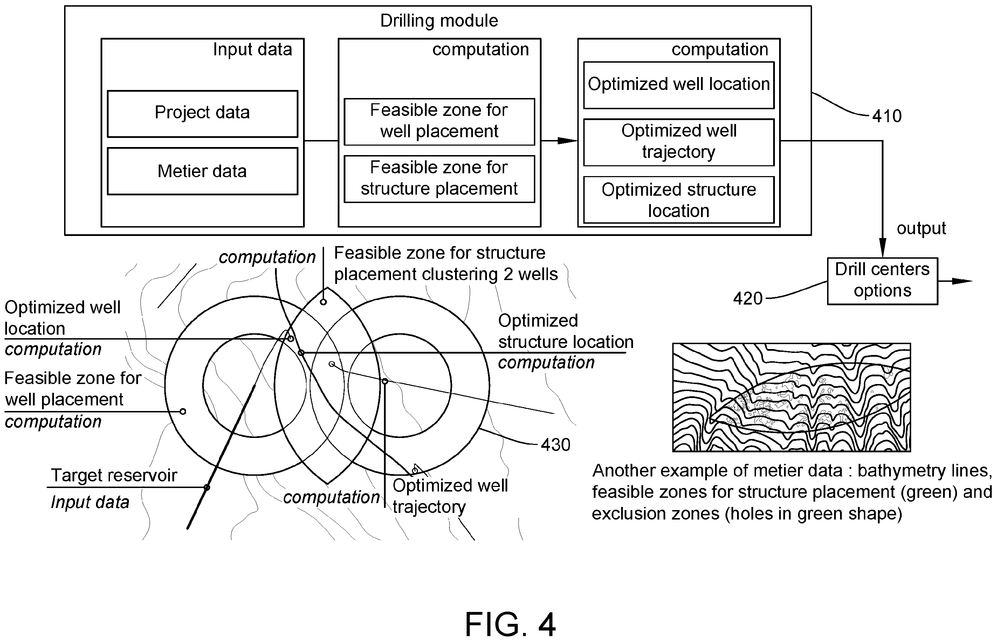

FIG. 4 illustrates the drilling module 410. The drilling module 410 performs the determination S20 of the one or more optimal locations each of an injection well or of a production well by optimizing, based on the inputs, a well location and a well flowline trajectory. The drilling module may be explained as receiving the input data provided at S10 (i.e., the project data and metier data as explained above), computing a feasible zone for well placement, and a feasible zone for structure placement. Based on the feasible zones, the drilling module computes an optimized well location, an optimized well trajectory and an optimized structure location, the result of the optimization is output as a drill center option S20.

The computation may be illustrated via the diagram 430, taking into account all of the input data and the feasible zones.

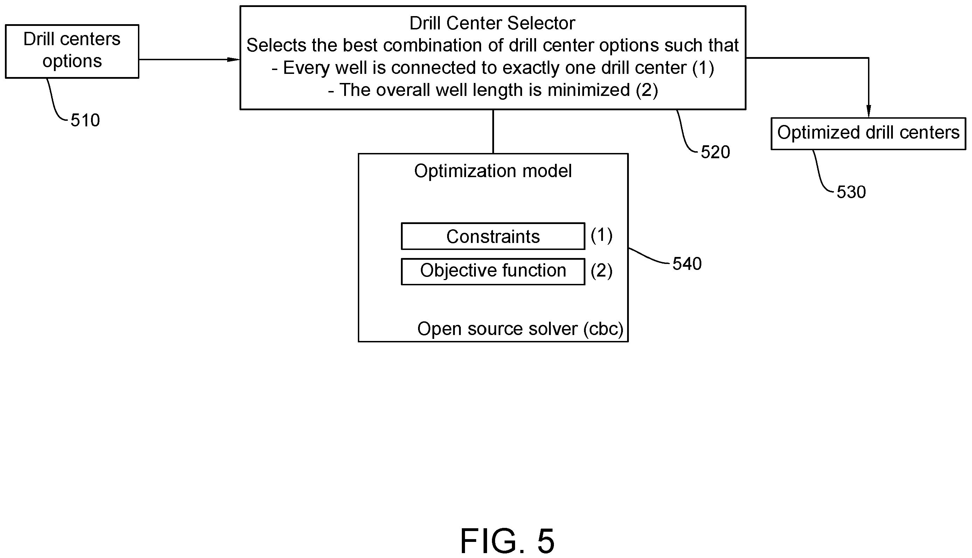

FIG. 5 illustrates the drill center selector module configured to perform the determination S30 of one or more optimal locations each of a drill center by performing an optimization, based on the inputs provided at S10 and on the determined optimal locations output by the determination S20, 510.

The optimization 520 performed at S40 is based on rewarding the following criteria: every well is connected to exactly one drill center and the overall drilled length and number of drill centers is minimized. This results in an optimized drill center output 530.

The optimization is based on an optimization model cbc 540, which comprises constraints and an objective function.

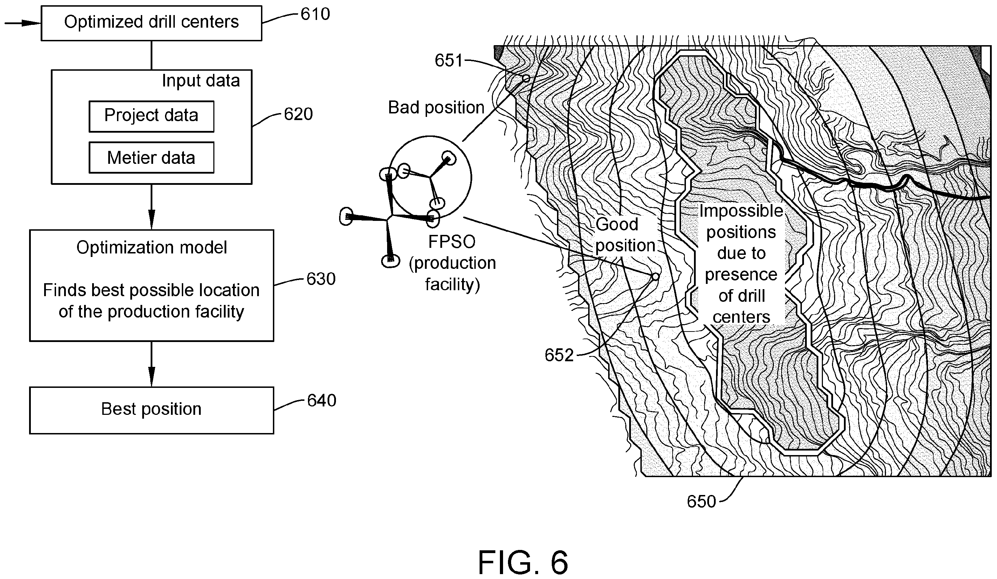

FIG. 6 illustrates the determination S40 of a location and orientation for the surface facility or the processing facility based on metocean data and the determined locations each of a drill center.

The determination takes into account optimal locations of drill centers 610 determined at S30.

The optimization is based on the inputs 620 provided at S10. An optimization model 630 determines the optimal locations 640 of the surface facility or the processing facility.

An example of the location is shown in the map 650. The map is based in metocean data. The map 650 shows an impossible position for a production facility due to the presence of a drill center. A good position 651 (i.e., optimal) and a bad position 652 (i.e., suboptimal) may be determined relative to the input and the presence of drill centers.

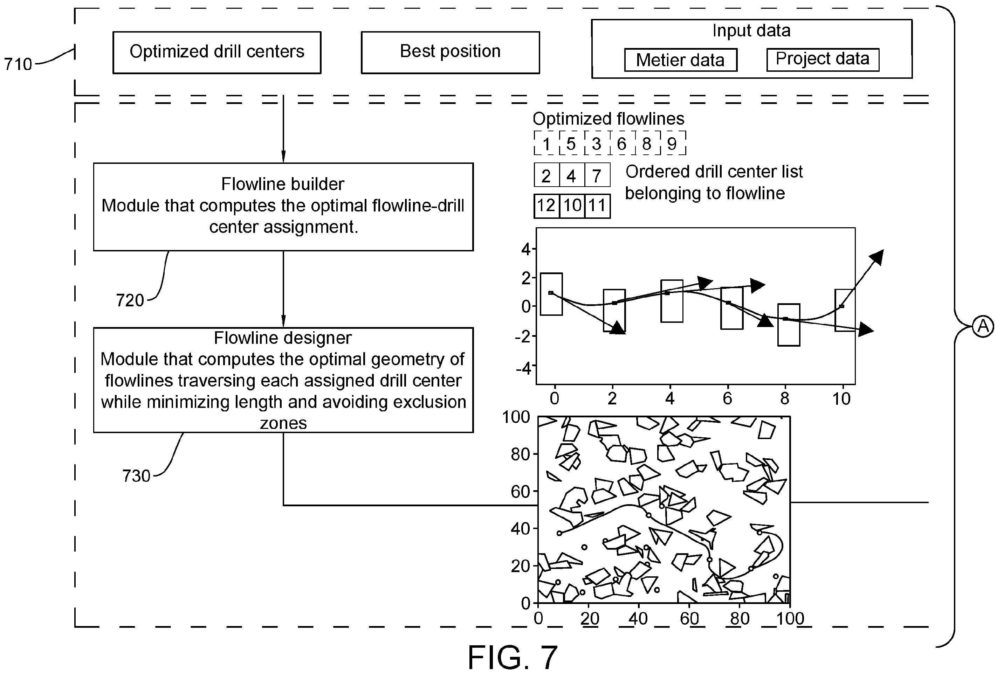

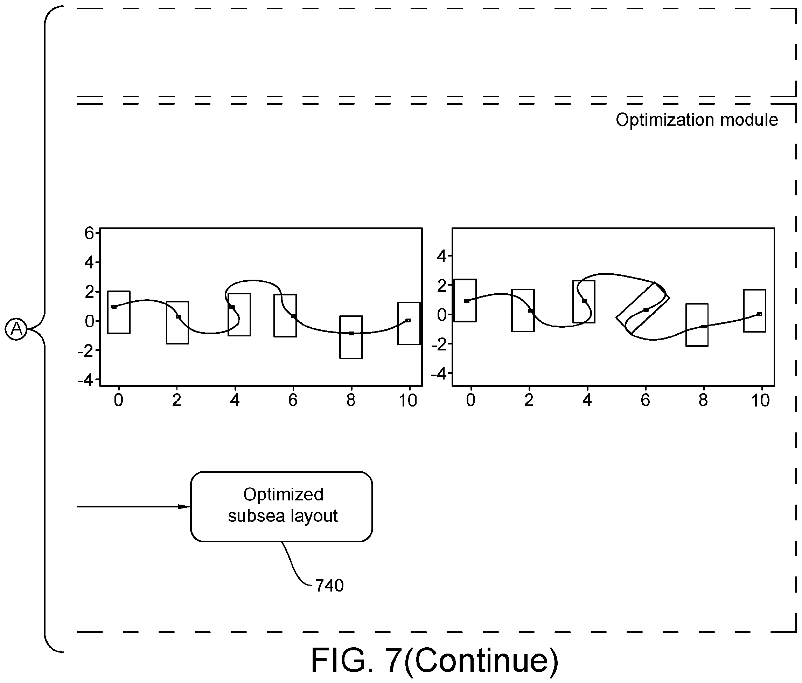

FIG. 7 illustrates the optimization module for performing the layout S50.

The module takes as input the drill center locations determined at S40 with the input data.

The module comprises a flowline builder 720. The flowline builder is configured for computing the optimal flowline-drill center assignment, i.e., flowlines connecting the drill centers.

The module also comprises a flowline designer 730 configured to compute the optimal geometry of flowlines traversing each assigned drill center while minimizing length and avoiding exclusion zones based on the input by S10.

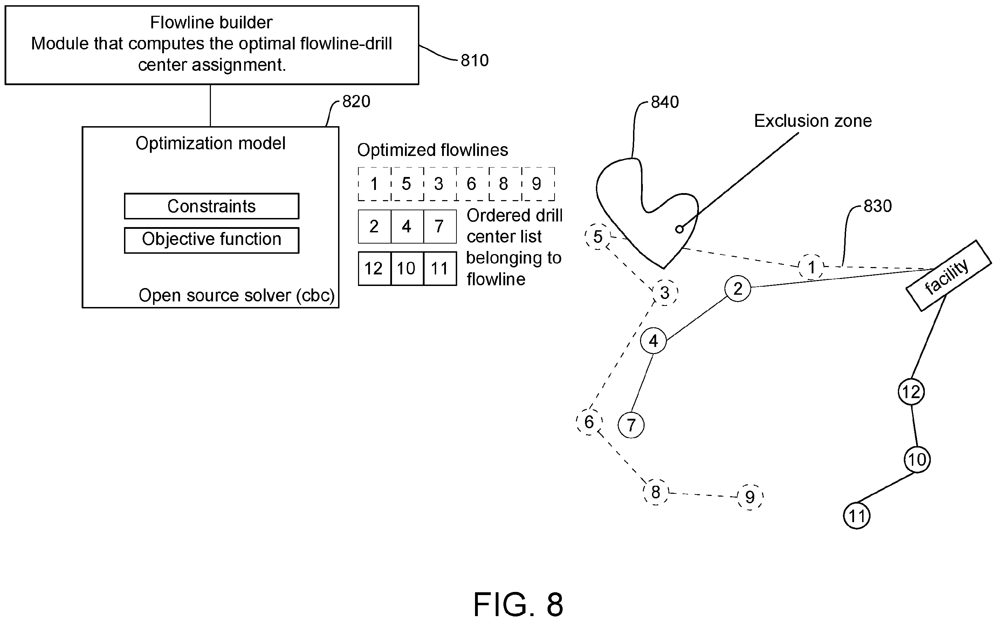

FIG. 8 illustrates the determination S50.The determination may comprise a flowline builder that computes the optimal layout of flowlines between the surface facility or the processing facility and the drill centers 810 with an optimization process 820 that aims at minimizing a total length of the flowlines while respecting mechanical constraints and/or installation constraints on the flowlines, the optimization process including one or more iterations of: computing a solution to the optimization; and by the user, defining one or more mechanical constraints and/or installation constraints on the flowlines to find another solution.

The flowline may be a 3D path on a grid, connected by different links. The optimization is perform to prevent passing through exclusion zones 840 as provided by the input data.

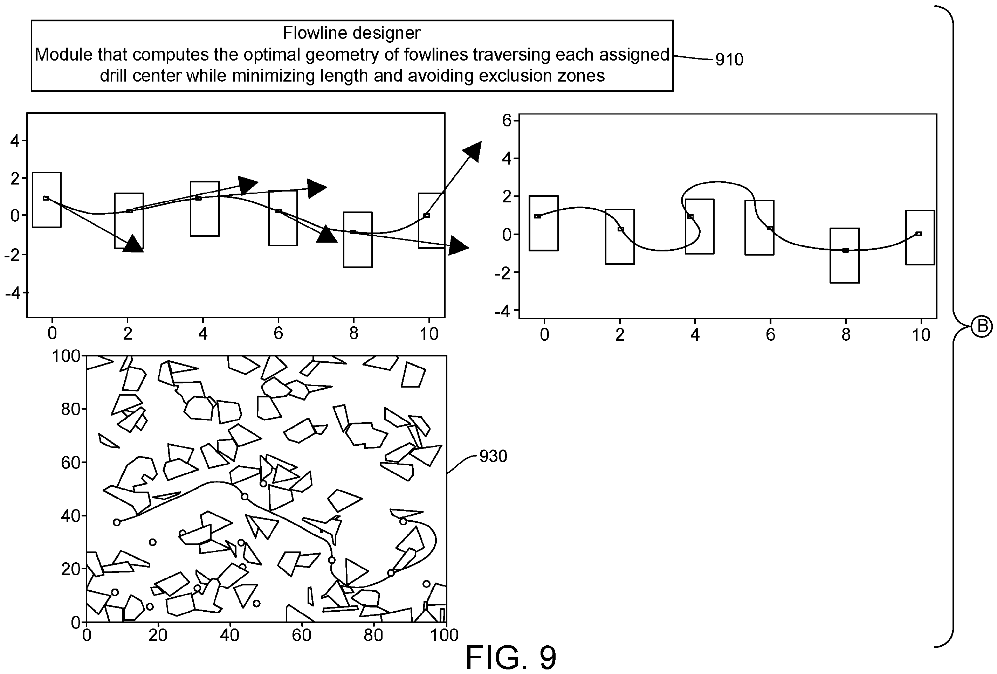

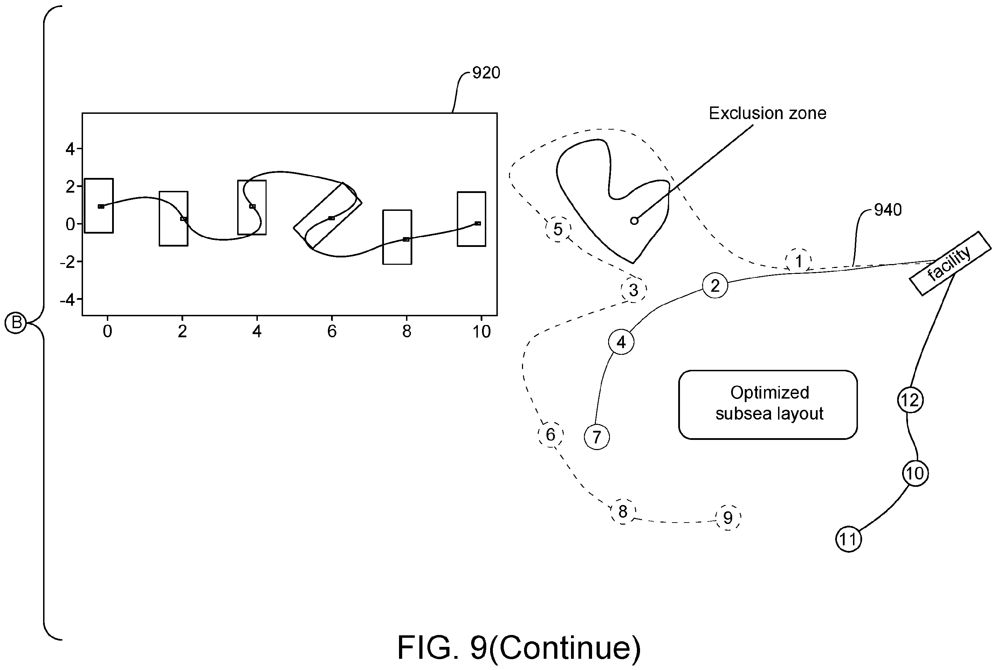

FIG. 9 illustrates the determination S50. The determination also comprises a flowline designer that computes the optimal geometry of flowlines traversing each center while minimizing length and avoiding exclusion zones 910. In other words, the determination optimizes the layout of flowlines so as to provide a physically relevant result, as the flowlines respect mechanical constraints and/or installation constraints 920 (e.g., curvature) while avoiding exclusion zones 930. The result is a smooth path 940 that connects the drill centers while avoiding exclusion zones.

## Claims

1. A computer-implemented method for optimizing a layout of a subsea oil & gas field on a portion of the seabed, the method comprising:
- providing (S10) inputs, the inputs including data specifying:
∘ one or more seabed locations unsuitable for well location based on terrain exclusion zones; and
∘ one or more injection or production targets to hydrocarbon reservoirs;
- determining (S20) one or more optimal locations each of an injection well or of a production well by optimizing, based on the inputs, a well location and a well trajectory;
- determining (S30) one or more optimal locations each of a drill center by performing an optimization, based on the inputs and on the determined optimal locations each of an injection well or of a production well, that rewards the following criteria:
∘ every well is connected to exactly one drill center; and
∘ the overall drilled length and number of drill centers is minimized;
- determining (S40) a location and orientation for surface facility or processing facility based on metocean data and/or marine regulation constraints and the determined locations each of a drill center; and
- determining (S50) a layout of flowlines of the subsea oil & gas field for connection between the surface facility or processing facility and the drill centers by performing an optimization process that aims at minimizing a total length of the flowlines while respecting mechanical constraints and/or installation constraints on the flowlines, the optimization process including one or more iterations of:
∘ computing a solution to the optimization; and
∘ by the user, defining one or more mechanical constraints and/or installation constraints on the flowlines to find another solution.

2. The method of claim 1, wherein computing the solution comprises applying a column generation algorithm that provides an optimal flowline deployment solution.

3. The method of claim 1 or 2, wherein the one or more mechanical constraints and/or installation constraints comprises one or more of:
- no flowline intersection;
- maximal and/or minimal flowline curvature;
- forbidding of a connection;
- locking and/or forcing a connection; and/or
- modifying the local geometry of a flowline by adding waypoints, changing curvature, straight line portions at drill center neighborhood.

4. The method of any one of claims 1 to 3, wherein computing a solution to the optimization comprises:
- optimizing a flowline-drill center assignment; and
- optimizing a geometry of the flowlines traversing each assigned drill center while minimizing length and avoiding exclusion zones.

5. The method of any one of claims 1 to 4, wherein the data specifying one or more target hydrocarbon reservoirs and one or more seabed locations unsuitable for well location include data specifying one or more of the following:
- target reservoir coordinates;
- bathymetry;
- pockmarks;
- slopes;
- zones excluded because of shipwrecks and/or biodiversity; and/or
- existing facilities.

6. The method of any one of claims 1 to 5, wherein the inputs further include data specifying one or more of the following:
- a type of the surface facility or processing facility;
- flowline types;
- riser types technologies and constraints;
- allowed curvatures, crossings, pipebrakes; and/or
- drilling constraints, including DogLegSeverity, allowed azimuth change, allowed deviation, allowed maximum trajectory slant, allowed terrain for wellhead and/or structure placement.

7. The method of any one of claims 1 to 7, further comprising minimizing development metrics including a type of flowline and riser and/or an incentive for additional structures.

8. A computer program comprising instructions for performing the method of any one of claims 1 to 7.

9. A computer-readable data storage medium having recorded thereon the computer program of claim 8.

10. A computer system comprising a processor coupled to a memory, the memory having recorded thereon the computer program of claim 8.
